# EUROPÄISCHE PATENTSCHRIFT

(11) **EP 3 449 494 B1**
(45) Veröffentlichungstag und Bekanntmachung des Hinweises auf die Patenterteilung: **28.05.2025**
(21) Anmeldenummer: 17719588.0
(22) Anmeldetag: 26.04.2017
(51) Int. Cl.: H10N 30/30

(54) **VIELSCHICHTBAUELEMENT UND VERWENDUNG VON AUSSENELEKTRODEN**
MULTILAYER COMPONENT AND USE OF OUTER ELECTRODES
COMPOSANT MULTICOUCHE ET UTILISATION D'ÉLECTRODES EXTÉRIEURES

(30) Priorität: 26.04.2016 DE 202016102203 U; 11.05.2016 DE 102016108694
(43) Veröffentlichungstag der Anmeldung: 06.03.2019
(73) Patentinhaber: TDK Electronics AG, 81671 München (DE)
(72) Erfinder: GALLER, Martin, 8401 Kalsdorf (AT)
(74) Vertreter: Epping - Hermann - Fischer
(86) Internationale Anmeldenummer: PCT/EP2017/059864
(87) Internationale Veröffentlichungsnummer: WO 2017/186759

(56) Entgegenhaltungen:
- DE-A1- 102009 029 571
- US-A1- 2013 241 360
- US-A1- 2016 056 366

## Beschreibung

Die Erfindung betrifft ein Vielschichtbauelement insbesondere ein keramisches Vielschichtbauelement. Die Erfindung betrifft ferner die Verwendung von Außenelektroden für ein Vielschichtbauelement.

Bei vielen Vielschichtbauelementen ist es für die Performance wichtig, dass positive und negative Polarität am Vielschichtbauelement richtig mit den entsprechenden Polaritäten der Ansteuerung verbunden werden. Dies ist im Allgemeinen dann der Fall, wenn in der Keramik Ordnungszustände hergestellt werden müssen, um die Performance des Vielschichtbauelements sicher zu stellen. Ein typisches Beispiel ist der Prozessschritt der Polarisation bei PZT (Blei-Zirkonat-Titanat) Vielschichtbauelementen, bei dem es zur Ausrichtung von Domänen unter dem Einfluss eines elektrischen Feldes kommt. Für solche Vielschichtbauelemente muss die in der Herstellungskette festgelegte Polaritätszuordnung in weiteren Prozessschritten bekannt bleiben.

US 2016/056366 A1 zeigt eine keramische Vielschichtstruktur, mit einer ersten C-förmigen Außenelektrode, die eine Außenseite der Vielschichtstruktur vollständig bedeckt und mit einer Oberseite und einer Unterseite der Vielschichtstruktur jeweils teilweise überlappt, und einer zweiten L-förmigen Außenelektrode, die eine zweite Außenfläche vollständig bedeckt und die eine Unterseite der Vielschichtstruktur teilweise bedeckt. DE 102009029571 A1 zeigt einen Piezoaktor, auf dessen einen Außenseite eine erste Außenelektrode und eine Zuschaltelektrode angeordnet sind.

Aus der US 2013/241360 A1 ist ein piezoelektrisches Vielschichtbauelement bekannt, bei dem eine Außenelektrode eine Einkerbung zur Kenntlichmachung der Polarität aufweist.

Bekannt ist beispielsweise das polaritätsrichtige Aufdrucken einer Beschriftung oder das polaritätsrichtige Anbringen einer Fase am Vielschichtbauelement.

Eine zu lösende Aufgabe besteht darin, ein verbessertes Vielschichtbauelement sowie die Verwendung von verbesserten Außenelektroden für ein Vielschichtbauelement anzugeben. Diese Aufgabe wird durch das elektronische Bauelement gemäß Anspruch 1 und die Verwendung gemäß Anspruch 8 gelöst.

Gemäß einem Aspekt wird ein Vielschichtbauelement angegeben. Das Vielschichtbauelement weist einen Grundkörper auf. Der Grundkörper weist eine Vielzahl von alternierend angeordneten keramischen Schichten und Innenelektroden auf. Die keramischen Schichten weisen beispielsweise ein mit Nd dotiertes PZT-Material auf. Die Innenelektroden weisen beispielsweise Silber und / oder Palladium auf. Die Innenelektroden sind beispielsweise in einem Abstand von 0,1 mm bis 0,8 mm, beispielsweise von 0,4 mm +/- 0,05 mm zueinander angeordnet. Der Abstand entspricht ungefähr der Dicke der keramischen Schichten.

Das Bauelement weist wenigstens zwei Außenelektroden zur elektrischen Kontaktierung der Innenelektroden auf. Beispielsweise weist das Vielschichtbauelement wenigstens eine erste Innenelektrode, die mit einer ersten Außenelektrode elektrisch verbunden ist, und eine zweite Innenelektrode, die mit einer zweiten Außenelektrode elektrisch verbunden ist, auf.

Die Außenelektroden sind beispielsweise schichtförmig auf gegenüberliegenden Seitenflächen des Grundkörpers angeordnet. Insbesondere können die Außenelektroden als Sputterschichten ausgebildet sein. Die Außenelektroden können die Materialien Chrom, Nickel und Silber aufweisen. Beispielsweise weisen die Außenelektroden einen CrNiAg-Schichtaufbau auf.

Das Vielschichtbauelement weist genau zwei auf gegenüberliegenden Seitenflächen des Grundkörpers angeordnete Außenelektroden auf.

Die zwei Außenelektroden weisen eine unterschiedliche Polarität auf. Bei der Herstellung des Vielschichtbauelements werden die keramischen Schichten durch Anlegen einer elektrischen Spannung zwischen den Außenelektroden polarisiert. Diese Polarisation legt den elektrischen Anschluss des Vielschichtbauelements im Betrieb fest. Insbesondere ist eine der Außenelektroden als positive Außenelektrode und eine der Außenelektroden als negative Außenelektrode ausgebildet.

Die Außenelektroden weisen eine unterschiedliche Anordnung an einer Außenfläche des Grundkörpers zur Kenntlichmachung der unterschiedlichen Polaritätszuordnung auf. Zusätzlich können die Außenelektroden eine unterschiedliche geometrische Form und / oder eine unterschiedliche Größe aufweisen.

Insbesondere sind die Außenelektroden derart ausgebildet, dass ihre Aufsichten nicht durch Drehung ineinander überführbar sind.

Die unterschiedliche Ausführung der Außenelektroden dient zur Kenntlichmachung der unterschiedlichen Polarität der Außenelektroden. In der Prozesskette findet das Aufbringen der Außenelektroden stets vor dem Prozessschritt der Ordnungsherstellung in der Keramik statt, da hierzu ansteuerbare Innenelektroden erforderlich sind. Wird dieser Prozessschritt lagerichtig zu den bereits vorhandenen Polaritätsmarkierungen durchgeführt, so kann in weiterer Folge immer die Polarität am Vielschichtbauelement erkannt werden.

Durch die immer am Vielschichtbauelement vorhandenen Außenelektroden kann somit auf einfache und kostengünstige Art und Weise die Polarität markiert werden. Den Außenelektroden wird dabei eine zusätzliche Funktion zugeordnet. Zusätzlicher Aufwand für das Aufbringen einer Polaritätsmarkierung kann entfallen, da die Außenelektrode in jedem Fall angebracht werden muss. Die korrekte Montage des Vielschichtbauelements, insbesondere der korrekte elektrische Anschluss der Außenelektroden wird auf einfache und kostengünstig sichergestellt. Damit wird ein kostengünstiges, einfaches und verbraucherfreundliches Vielschichtbauelement zur Verfügung gestellt.

Gemäß einem Ausführungsbeispiel weist die erste Außenelektrode eine kleinere Fläche auf als die zweite Außenelektrode oder umgekehrt. Insbesondere weisen die Außenelektroden zur Polaritätsmarkierung unterschiedliche Flächen auf. Entscheidend ist, dass wenigstens eine der Außenelektroden in ihrer Abmessung über das Maß, das für die eigentliche Funktion der jeweiligen Außenelektrode erforderlich ist vergrößert ist. Die weitere Außenelektrode kann eine Fläche bzw. Abmessung aufweisen, die exakt für die eigentliche Funktion der Außenelektrode erforderlich ist. Damit kann die Polarität der Außenelektroden auf einfache Art und Weise unterschieden werden.

Gemäß einem Ausführungsbeispiel weisen die Außenelektroden jeweils eine Breite in einer Richtung senkrecht zu einer Stapelrichtung der keramischen Schichten auf. Die Breite der ersten Außenelektrode ist kleiner als die Breite der zweiten Außenelektrode. Auch der umgekehrte Fall ist denkbar, dass die Breite der zweiten Außenelektrode kleiner ist als die Breite der ersten Außenelektrode.

Die Außenelektroden weisen jeweils eine Höhe in einer Richtung parallel zu einer Stapelrichtung der keramischen Schichten auf. Die Höhe der ersten Außenelektrode kann größer sein als die Höhe der zweiten Außenelektrode oder umgekehrt.

In einem Ausführungsbeispiel weisen die Außenelektroden die selbe Höhe, jedoch unterschiedliche Breiten auf. In einem Ausführungsbeispiel weisen die Außenelektroden die selbe Breite, jedoch unterschiedliche Höhen auf.

Gemäß einem Ausführungsbeispiel weist die erste Außenelektrode eine rechteckige Form auf und die zweite Außenelektrode weist eine runde Form auf oder umgekehrt.

Gemäß einem Ausführungsbeispiel weist das Vielschichtbauelement eine gebrochene Rotationssymmetrie auf. Der Grundkörper weist einander gegenüberliegende Seitenflächen auf, wobei eine der Außenelektroden zu einer die jeweilige Seitenfläche begrenzende Kante hin versetzt angeordnet ist. Das Vielschichtbauelement ist beispielsweise unsymmetrisch bezüglich einer Rotation um 180° um eine vertikale Achse, die in Stapelrichtung des Vielschichtbauelements verläuft.

Gemäß einem Ausführungsbeispiel ist das Vielschichtbauelement als Piezovielschichtaktuator, als Vielschichtdrucksensor oder als Keramikkondensator ausgebildet.

Der Drucksensor ist beispielsweise als NCS-Sensor (needle closing sensor) ausgebildet, der das Schließen einer Ventilnadel eines Brennstoffeinspritzventils überwacht. Der Drucksensor ist beispielsweise derart ausgebildet, dass bei Einwirkung eines Drucks auf eine Oberseite und / oder eine Unterseite des Grundkörpers ein elektrisches Signal an den Außenelektroden abgreifbar ist. Die Oberseite und Unterseite sind dabei die Seiten, die den Grundkörper in Stapelrichtung der Schichten, nach oben und unten abschließen. Die Außenelektroden sind vorzugsweise an Seitenflächen angeordnet, die nicht die Oberseite und nicht die Unterseite des Stapels bilden. Insbesondere sind die Seitenflächen senkrecht zur Oberseite und Unterseite angeordnet.

Gemäß einem weiteren Aspekt wird die Verwendung von Außenelektroden beschrieben. Die Außenelektroden entsprechen vorzugsweise den oben beschriebenen Außenelektroden. Alle Merkmale, welche in Zusammenhang mit den Außenelektroden sowie dem Vielschichtbauelement beschrieben wurden, finden auch für die Verwendung Anwendung und umgekehrt.

Die oben beschriebenen Außenelektroden werden für ein wie oben beschriebenes Vielschichtbauelement verwendet. Die Außenelektroden werden zur Kennzeichnung der unterschiedlichen Polaritäten der Außenelektroden, insbesondere zur Polaritätsmarkierung am Vielschichtbauelement verwendet. Die Außenelektroden weisen eine unterschiedliche Anordnung auf einem Grundkörper des Vielschichtbauelements zur Polaritätsmarkierung auf. Die Außenelektroden weisen damit eine zusätzliche Funktion auf, durch die auf einfache und kostengünstige Weise die Polarität am Vielschichtbauelement gekennzeichnet werden kann.

Die Erfindung wird im Folgenden anhand von Ausführungsbeispielen und den dazugehörigen Figuren näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.
- Figur 1: zeigt eine schematische Schnittansicht eines Vielschichtbauelements gemäß dem Stand der Technik,
- Figur 2a: zeigt eine perspektivische Ansicht eines Vielschichtbauelements gemäß einem ersten Ausführungsbeispiel,
- Figur 2b: zeigt eine Draufsicht auf das Vielschichtbauelement gemäß Figur 2a,
- Figur 3a: zeigt eine perspektivische Ansicht eines Vielschichtbauelements gemäß einem Vergleichsbeispiel, welches nicht unter den Gegenstand des Schutzbegehrens fällt.

- Figur 3b: zeigt eine perspektivische Ansicht des um 180° rotierten Vielschichtbauelements gemäß Figur 3a,
- Figur 4a: zeigt eine perspektivische Ansicht eines Vielschichtbauelements gemäß einem weiteren Ausführungsbeispiel,
- Figur 4b: zeigt eine perspektivische Ansicht des um 180° rotierten Vielschichtbauelements gemäß Figur 4a.

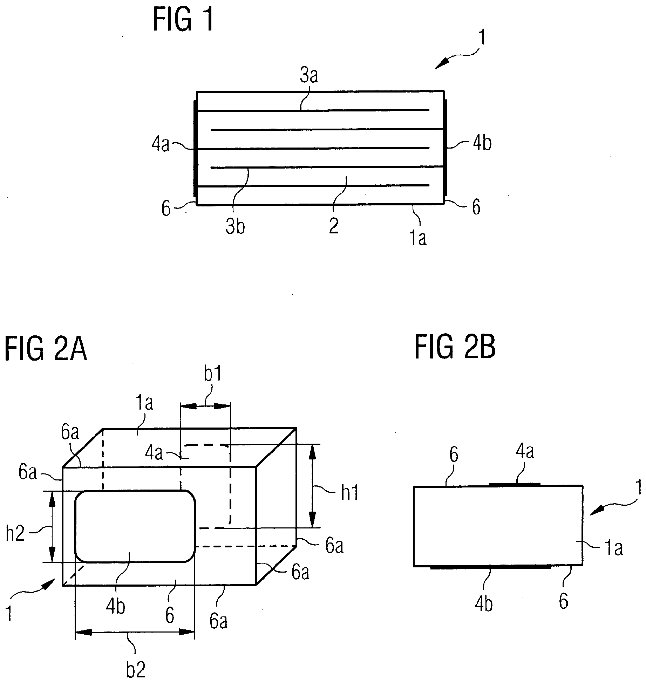

Die Figur 1 zeigt eine schematische Schnittansicht eines Vielschichtbauelements gemäß dem Stand der Technik.

Das Vielschichtbauelement 1 weist einen Grundkörper 1a auf. Der Grundkörper 1a weist eine Vielzahl von keramischen Schichten 2 auf. Insbesondere handelt es sich bei den keramischen Schichten 2 um piezokeramische Schichten. Die keramischen Schichten 2 weisen beispielsweise ein mit Nd dotiertes PZT-Material auf.

Zwischen den keramischen Schichten 2 sind Innenelektroden 3a, 3b angeordnet. Die Innenelektroden 3a, 3b weisen beispielsweise eine Legierung aus Silber und Palladium auf.

Die Innenelektroden 3a, 3b dienen der elektrischen Ansteuerung der keramischen Schichten 2. Die keramischen Schichten 2 und die Innenelektroden 3a, 3b sind übereinander zu einem Stapel angeordnet. Eine Mehrzahl von Innenelektroden 3a, 3b führt jeweils wechselseitig an einer Seitenfläche 6 des Grundkörpers 1a aus dem Grundkörper 1a heraus. Insbesondere reichen unterschiedlicher Polarität zugeordnete Innenelektroden 3a, 3b an jeweils gegenüberliegenden Seitenflächen 6 des Grundkörpers 1a bis an die Oberfläche des Grundkörpers 1a.

Das Vielschichtbauelement 1 weist zwei Außenelektroden 4a, 4b auf, die an gegenüberliegenden Seitenflächen 6 des Grundkörpers 1a angeordnet sind. Die Außenelektroden 4a, 4b können als eingebrannte metallische Schichten ausgebildet sein. Die Außenelektroden 4a, 4b sind vorzugsweise als gesputterte Schichten ausgebildet. Beispielsweise können die Außenelektroden 4a, 4b eine Sputterschicht aus CrNiAg aufweisen. Die Innenelektroden 3a, 3b sind in Stapelrichtung abwechselnd mit einer der Außenelektroden 4a, 4b elektrisch leitend verbunden und von der anderen Außenelektrode 4b, 4a elektrisch isoliert. Die Außenelektroden 4a, 4b verbinden also die Innenelektroden 3a, 3b und ermöglichen ihre gemeinsame Ansteuerung.

Das Vielschichtbauelement 1 kann beispielsweise einen Piezovielschichtaktuator, einen Vielschichtdrucksensor oder einen Keramikkondensator aufweisen. Die keramischen Schichten 2 stellen das eigentliche funktionale Element des Vielschichtbauelements 1 dar. Beim Anlegen einer elektrischen Spannung an die Innenelektroden 3a, 3b realisieren sie je nach Typ des Vielschichtbauelements 1 Kapazität, mechanischen Hub oder Sensorsignaloutput.

Bei der Herstellung des Vielschichtbauelements 1 werden die keramischen Schichten 2 durch Anlegen einer elektrischen Spannung zwischen den Außenelektroden 4a, 4b polarisiert. Bei der Polarisierung des Vielschichtbauelements 1 wird beispielsweise die erste Außenelektrode 4a mit einem Minuspol einer Spannungsquelle und die zweite Außenelektrode 4b mit einem Pluspol einer Spannungsquelle verbunden. Entsprechend kann die erste Außenelektrode 4a als Minus-Elektrode / negative Außenelektrode und die zweite Außenelektrode 4b als als Plus-Elektrode / positive Außenelektrode bezeichnet werden. Selbstverständlich ist auch die umgekehrte Zuordnung möglich. So kann auch die zweite Außenelektrode 4b als Minus-Elektrode / negative Außenelektrode und die erste Außenelektrode 4a als Plus-Elektrode / positive Außenelektrode angelegt werden.

Für die elektrische Performance des Vielschichtbauelements 1 ist es wesentlich, dass positive und negative Polarität am Vielschichtbauelement 1 richtig mit den entsprechenden Polaritäten der Ansteuerung verbunden werden. Die Figuren 2a bis 4b behandeln daher Ausführungsformen durch die die Polarität am Vielschichtbauelement 1 gekennzeichnet werden kann. Das den Figuren 2a bis 4b zu Grunde liegende Vielschichtbauelement 1 entspricht dabei im Wesentlichen dem Vielschichtbauelement 1 gemäß der Figur 1 mit Ausnahme der Form, Abmessung und / oder Anordnung der Außenelektroden 4a, 4b.

Figur 2a zeigt eine perspektivische Ansicht eines Vielschichtbauelements gemäß einem ersten Ausführungsbeispiel. Figur 2b zeigt eine Draufsicht auf das Vielschichtbauelement gemäß Figur 2a.

In diesem Ausführungsbeispiel weisen beide Außenelektroden 4a, 4b eine rechteckige Form auf. Es sind aber auch andere geometrische Formen für die Außenelektroden 4a, 4b vorstellbar, beispielsweise eine Kreisform.

Zur Polaritätsmarkierung an dem Vielschichtbauelement 1 werden unterschiedliche Abmessungen der Außenelektroden 4a, 4b verwendet. In diesem Ausführungsbeispiel weist die erste Außenelektrode 4a eine Breite b1 auf, welche kleiner ist als die Breite b2 der zweiten Außenelektrode 4b. Die Breite der Außenelektroden 4a, 4b bezeichnet dabei diejenige Ausdehnung der Außenelektroden 4a, 4b welche sich in einer Richtung senkrecht zu einer Stapelrichtung der keramischen Schichten 2 erstreckt. Beispielsweise ist die Breite b1 der ersten Außenelektrode 4a halb so groß wie die Breite b2 der zweiten Außenelektrode. Dabei bezeichnet die erste Außenelektrode 4a in diesem Ausführungsbeispiel die negative Außenelektrode und die zweite Außenelektrode 4b entspricht der positiven Außenelektrode 4b.

Die Höhe h1 der ersten Außenelektrode 4a ist ferner größer als die Höhe h2 der zweiten Außenelektrode 4b. Die Höhe h1, h2 der Außenelektroden 4a, 4b bezeichnet dabei diejenige Ausdehnung der Außenelektroden 4a, 4b in einer Richtung parallel zu einer Stapelrichtung der keramischen Schichten 2. Insgesamt weist die erste Außenelektrode 4a eine kleinere Fläche auf als die zweite Außenelektrode 4b. So beträgt die Fläche der ersten Außenelektrode 4a beispielsweise das 0,4-bis 0,7-fache der Fläche der zweiten Außenelektrode. Beispielsweise ist die Fläche der ersten Außenelektrode 4a halb so groß wie die Fläche der zweiten Außenelektrode.

Selbstverständlich kann die Polaritätszuordnung aber auch umgekehrt sein, das heißt beispielsweise kann die Breite b1 der negativen Außenelektrode 4a größer sein als die Breite b2 der positiven Außenelektrode 4b. Die Höhe h1 der negativen Außenelektrode 4a kann kleiner sein als die Höhe h2 der positiven Außenelektrode 4b. Die Fläche der negativen Außenelektrode 4a kann größer sein als die Fläche der positiven Außenelektrode 4b. Entscheidend ist, dass wenigstens eine der Außenelektroden 4a, 4b in ihrer Abmessung über das Maß, das für die eigentliche Funktion der jeweiligen Außenelektrode 4a, 4b erforderlich ist (die sichere elektrische Versorgung der Innenelektroden 3a, 3b) vergrößert ist.

Zusätzlich ist in diesem Ausführungsbeispiel die Rotationssymmetrie des Vielschichtbauelements 1 gebrochen. Insbesondere ist die erste Außenelektrode 4a nicht mittig auf einer Seitenfläche 6 des Grundkörpers 1a angeordnet. Vielmehr ist die erste Außenelektrode 4a zu einer die Seitenfläche 6 begrenzende Kante 6a hin versetzt angeordnet ist. Mit anderen Worten, in Aufsicht auf die betreffende Seitenfläche 6 ist die erste Außenelektrode 4a nach links in Richtung der Kante 6a der Seitenfläche hin verschoben. Selbstverständlich ist auch die Verschiebung der Außenelektrode 4a in eine andere Richtung vorstellbar. In Aufsicht auf die betreffende Seitenfläche 6 kann die erste Außenelektrode 4a nach links, rechts, oben oder unten in Richtung einer Kante 6a der Seitenfläche 6 hin verschoben sein.

Die zweite Außenelektrode 4b ist auf einer gegenüberliegenden Seitenfläche 6 hingegen mittig angeordnet. Auch durch die unterschiedliche Anordnung der Außenelektroden 4, 4b auf der jeweiligen Außenfläche kann die Polarität der Außenelektroden 4a, 4b kenntlich gemacht werden. So ist die negative Außenelektrode 4a zu einer Kante 6a hin verschoben, während die positive Außenelektrode 4b rotationssymmetrisch auf der Mitte der Seitenfläche 6 ausgebildet ist.

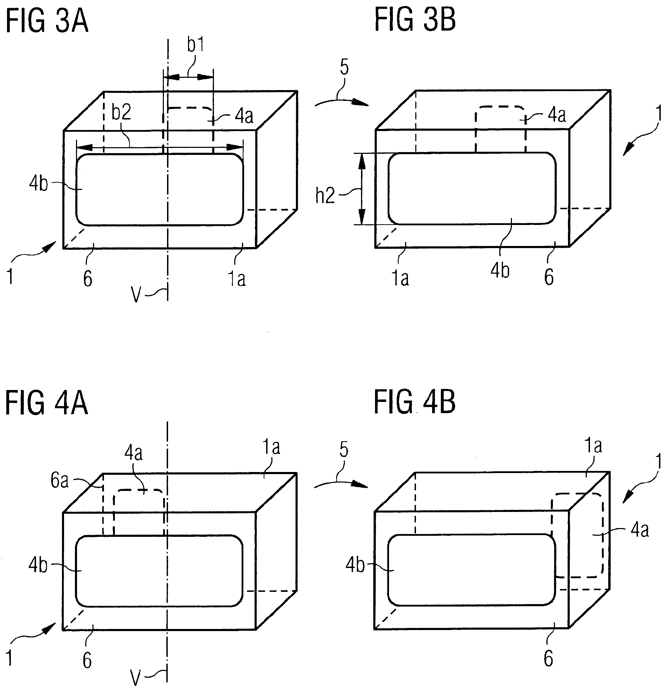

Selbstverständlich ist auch der umgekehrte Fall (mittige negative Außenelektrode 4a und versetzte positive Außenelektrode 4b) möglich. Durch die unterschiedliche Anordnung der Außenelektroden 4a, 4b auf der jeweiligen Seitenfläche 6 ist die Rotationssymmetrie des Vielschichtbauelements 1 gebrochen (siehe hierzu auch die Figuren 4a und 4b). Nach Rotation des Vielschichtbauelements 1 um 180° um eine vertikale Achse v (siehe Figuren 3a und 3b) ist die erste Außenelektrode 4a nach rechts in Richtung der Kante 6a der Seitenfläche hin verschoben (nicht explizit dargestellt).

Die beiden Außenelektroden 4a, 4b können zur Polaritätskennzeichnung alternativ oder zusätzlich auch unterschiedliche geometrische Formen aufweisen (nicht explizit dargestellt). So kann die erste Außenelektrode 4a eine Kreisform aufweisen und die zweite Außenelektrode 4b kann eine rechteckige Form aufweisen oder umgekehrt. Auch andere Formen sind für die Außenelektroden 4a, 4b vorstellbar, beispielsweise eine Trapezform. Wichtig im Fall der Polaritätskennzeichnung rein durch die geometrische Form ist dabei, dass die beiden Außenelektroden 4a, 4b eine unterschiedliche geometrische Form aufweisen.

Figur 3a zeigt eine perspektivische Ansicht eines Vielschichtbauelements gemäß einem Vergleichsbeispiel, welches nicht unter den Gegenstand des Schutzbegehrens fällt. Figur 3b zeigt eine perspektivische Ansicht des um 180° rotierten Vielschichtbauelements gemäß der Figur 3a.

Auch in diesem Ausführungsbeispiel weist die erste Außenelektrode 4a eine Breite b1 auf, welche kleiner ist als die Breite b2 der zweiten Außenelektrode 4b. Die erste Außenelektrode 4a weist eine Höhe h1 auf, welche größer ist als die Höhe h2 der zweiten Außenelektrode 4b. Insgesamt weist die erste Außenelektrode 4a eine kleinere Fläche auf als die zweite Außenelektrode 4b. Auf diese Weise kann die Polarität der beiden Außenelektroden 4a, 4b auf einfache Art und Weise markiert und somit unterschieden werden.

Die Breite b1 der ersten Außenelektrode 4a ist jedoch kleiner als die Breite b1 der ersten Außenelektrode 4a gemäß der Figuren 2a, 2b. Mit anderen Worten, die erste Außenelektrode 4a ist in diesem Ausführungsbeispiel besonders schmal ausgeführt. Die Höhe h1 der ersten Außenelektrode 4a ist größer als die Höhe h1 der ersten Außenelektrode 4a gemäß der Figuren 2a, 2b. Mit anderen Worten, die erste Außenelektrode 4a ist in diesem Ausführungsbeispiel besonders lang ausgeführt. Beispielsweise weist die erste Außenelektrode 4a in diesem Ausführungsbeispiel eine Fläche auf, die genau das Maß hat, welche für die eigentliche Funktion der Außenelektrode erforderlich ist.

Die Breite b2 der zweiten Außenelektrode 4b ist hingegen größer als die Breite b2 der zweiten Außenelektrode 4b gemäß der Figuren 2a, 2b. Die Höhe h2 der zweiten Außenelektrode 4b ist kleiner als die Höhe h2 der zweiten Außenelektrode 4b gemäß der Figuren 2a, 2b. Somit sind viele verschiedene Abmessungen bzw. Flächen für die betreffenden Außenelektroden 4a, 4b vorstellbar, solange die jeweilige Außenelektrode 4a, 4b eine minimale Abmessung aufweist, die für die eigentliche Funktion der Außenelektrode 4a, 4b, nämlich die elektrische Versorgung der Innenelektroden 3a, 3b, erforderlich ist.

Ferner ist im Gegensatz zu dem Ausführungsbeispiel gemäß den Figuren 2a und 2b hier die Rotationssymmetrie des Vielschichtbauelements 1 nicht gebrochen. Insbesondere sind sowohl die erste Außenelektrode 4a als auch die zweite Außenelektrode 4b mittig auf gegenüberliegenden Seitenflächen 6 des Grundkörpers 1a angeordnet. Nach Rotation des Vielschichtbauelements 1 um 180° (gekennzeichnet durch Pfeil 5) um die vertikale Achse v sind beide Außenelektroden 4a, 4b folglich weiterhin mittig auf der jeweiligen Seitenfläche 6 angeordnet.

Figur 4a zeigt eine perspektivische Ansicht eines Vielschichtbauelements gemäß einem weiteren Ausführungsbeispiel. Figur 4b zeigt eine perspektivische Ansicht des um 180° rotierten Vielschichtbauelements gemäß Figur 4a.

Im Unterschied zu dem in den Figuren 3a und 3b gezeigten Ausführungsbeispiel, ist die Rotationssymmetrie des Vielschichtbauelements 1 gemäß der Figuren 4a und 4b gebrochen. Die erste Außenelektrode 4a ist insbesondere nicht mittig auf einer Seitenfläche 6 des Grundkörpers 1a angeordnet, sondern zu einer die Seitenfläche 6 begrenzende Kante 6a hin versetzt angeordnet. In Aufsicht auf die betreffende Seitenfläche 6 ist die erste Außenelektrode 4a nach rechts in Richtung der Kante 6a der Seitenfläche 6 hin verschoben.

Die zweite Außenelektrode 4b ist auf einer gegenüberliegenden Seitenfläche 6 mittig angeordnet. Durch die unterschiedliche Anordnung der Außenelektroden 4, 4b auf der jeweiligen Außenfläche kann die Polarität der Außenelektroden 4a, 4b kenntlich gemacht werden.

Alle weiteren Merkmale des Vielschichtbauelements 1 gemäß der Figuren 4a und 4b entsprechen den in Zusammenhang mit den Figuren 3a und 3b beschriebenen Merkmalen.

### Bezugszeichenliste

- 1: Vielschichtbauelement
- 2: Keramische Schicht
- 3a, 3b: Innenelektrode
- 4a, 4b: Außenelektrode
- 5: Pfeil
- 6: Seitenfläche
- 6a: Kante

- b1, b2: Breite
- h1, h2: Höhe
- v: Vertikale Achse

## Patentansprüche

1. Vielschichtbauelement (1) aufweisend
- einen Grundkörper (1a) mit einer Vielzahl von alternierend angeordneten keramischen Schichten (2) und Innenelektroden (3a, 3b),
- eine erste Außenelektrode (4a) und eine zweite Außenelektrode (4b) zur elektrischen Kontaktierung der Innenelektroden (3a, 3b),
wobei die zwei Außenelektroden (4a, 4b) eine unterschiedliche Polaritätszuordnung aufweisen und wobei die Außenelektroden (4a, 4b) eine unterschiedliche Anordnung an einer Außenfläche des Grundkörpers (1a) zur Kenntlichmachung der unterschiedlichen Polaritätszuordnung aufweisen,
wobei das Vielschichtbauelement (1) genau zwei auf gegenüberliegenden Seitenflächen (6) des Grundkörpers (1a) angeordnete Außenelektroden (4a, 4b) aufweist, wobei jede der Außenelektroden (4a, 4b) von den Rändern der jeweiligen Seitenfläche (6) beabstandet ist,
wobei die erste Außenelektrode (4a) zu einer die Seitenfläche (6) begrenzenden Kante (6a) hin versetzt und somit nicht mittig auf der Seitenfläche des Grundkörpers (1a) angeordnet ist und wobei die zweite Außenelektrode (4b) auf der gegenüberliegenden Seitenfläche mittig angeordnet ist.

2. Vielschichtbauelement (1) nach Anspruch 1,
wobei die erste Außenelektrode (4a) eine kleinere Fläche aufweist als die zweite Außenelektrode (4b).

3. Vielschichtbauelement (1) nach einem der vorangehenden Ansprüche,
wobei die erste Außenelektrode (4a) eine rechteckige Form aufweist und wobei die zweite Außenelektrode (4b) eine runde Form aufweist oder umgekehrt.

4. Vielschichtbauelement (1) nach einem der Ansprüche 1 bis 3,
wobei das Vielschichtbauelement (1) eine gebrochene Rotationssymmetrie aufweist.

5. Vielschichtbauelement (1) nach einem der vorangehenden Ansprüche,
wobei das Vielschichtbauelement (1) als Piezovielschichtaktuator oder als Vielschichtdrucksensor ausgebildet ist.

6. Vielschichtbauelement (1) nach einem der vorangehenden Ansprüche,
wobei die Außenelektroden (4a, 4b) jeweils eine Breite (b1, b2) in einer Richtung senkrecht zu einer Stapelrichtung der keramischen Schichten (2) und eine Höhe (h1, h2) in einer Richtung parallel zu einer Stapelrichtung der keramischen Schichten (2) aufweisen,
wobei die Breite (b1) der ersten Außenelektrode (4a) kleiner ist als die Breite (b2) der zweiten Außenelektrode (4b) und/oder
wobei die Höhe (h1) der ersten Außenelektrode (4a) größer ist als die Höhe (h2) der zweiten Außenelektrode (4b).

7. Vielschichtbauelement (1) nach einem der vorangehenden Ansprüche,
wobei die Außenelektroden (4a, 4b) eine unterschiedliche geometrische Form und / oder eine unterschiedliche Größe aufweisen.

8. Verwendung von Außenelektroden (4a, 4b) zur Kennzeichnung der unterschiedlichen Polaritätszuordnung der Außenelektroden (4a, 4b) eines Vielschichtbauelements (1) gemäß einem der Ansprüche 1 bis 7.

9. Verwendung nach Anspruch 8,
wobei die Außenelektroden (4a, 4b) eine unterschiedliche geometrische Form und / oder eine unterschiedliche Größe aufweisen.

## Claims

1. Multilayer component (1) comprising
- a main body (1a) having a multiplicity of alternately arranged ceramic layers (2) and inner electrodes (3a, 3b),
- a first outer electrode (4a) and a second outer electrode (4b) for electrically contacting the inner electrodes (3a, 3b),
wherein the two outer electrodes (4a, 4b) have a different polarity assignment and wherein the outer electrodes (4a, 4b) have a different arrangement at an outer surface of the main body (1a) for identifying the different polarity assignment,
wherein the multilayer component (1) comprises exactly two outer electrodes (4a, 4b) arranged on opposite side surfaces (6) of the main body (1a), wherein each of the outer electrodes (4a, 4b) is spaced apart from the edges of the respective side surface (6),
wherein the first outer electrode (4a) is arranged offset towards an edge (6a) delimiting the side surface (6), and therefore not centrally on the side surface of the main body (1a), and wherein the second outer electrode (4b) is arranged centrally on the opposite side surface.

2. Multilayer component (1) according to Claim 1, wherein the first outer electrode (4a) has a smaller area than the second outer electrode (4b).

3. Multilayer component (1) according to either of the preceding claims,
wherein the first outer electrode (4a) has a rectangular shape and wherein the second outer electrode (4b) has a round shape, or vice versa.

4. Multilayer component (1) according to any of Claims 1 to 3,
wherein the multilayer component (1) has a broken rotational symmetry.

5. Multilayer component (1) according to any of the preceding claims,
wherein the multilayer component (1) is configured as a piezo-multilayer actuator or as a multilayer pressure sensor.

6. Multilayer component (1) according to any of the preceding claims,
wherein the outer electrodes (4a, 4b) each have a width (b1, b2) in a direction perpendicular to a stacking direction of the ceramic layers (2), and a height (h1, h2) in a direction parallel to a stacking direction of the ceramic layers (2),
wherein the width (b1) of the first outer electrode (4a) is smaller than the width (b2) of the second outer electrode (4b) and/or
wherein the height (h1) of the first outer electrode (4a) is greater than the height (h2) of the second outer electrode (4b).

7. Multilayer component (1) according to any of the preceding claims,
wherein the outer electrodes (4a, 4b) have a different geometric shape and/or a different size.

8. Use of outer electrodes (4a, 4b) for identifying the different polarity assignment of the outer electrodes (4a, 4b) of a multilayer component (1) according to any of Claims 1 to 7.

9. Use according to Claim 8,
wherein the outer electrodes (4a, 4b) have a different geometric shape and/or a different size.

## Revendications

1. Composant multicouche (1), présentant
- un corps de base (1a) avec une pluralité de couches céramiques (2) et d'électrodes intérieures (3a, 3b) agencées en alternance,
- une première électrode extérieure (4a) et une deuxième électrode extérieure (4b) pour établir un contact électrique avec les électrodes intérieures (3a, 3b),
les deux électrodes extérieures (4a, 4b) présentant une attribution de polarité différente et les électrodes extérieures (4a, 4b) présentant un agencement différent sur une surface extérieure du corps de base (1a) pour indiquer l'attribution de polarité différente,
le composant multicouche (1) présentant exactement deux électrodes extérieures (4a, 4b) agencées sur des surfaces latérales opposées (6) du corps de base (1a), chacune des électrodes extérieures (4a, 4b) étant espacée des bords de la surface latérale respective (6),
la première électrode extérieure (4a) étant décalée vers un bord (6a) délimitant la surface latérale (6) et n'étant donc pas agencée au centre sur la surface latérale du corps de base (1a), et la deuxième électrode extérieure (4b) étant agencée au centre sur la surface latérale opposée.

2. Composant multicouche (1) selon la revendication 1, la première électrode extérieure (4a) présentant une surface plus petite que la deuxième électrode extérieure (4b).

3. Composant multicouche (1) selon l'une quelconque des revendications précédentes,
la première électrode extérieure (4a) présentant une forme rectangulaire et la deuxième électrode extérieure (4b) présentant une forme circulaire ou vice versa.

4. Composant multicouche (1) selon l'une quelconque des revendications 1 à 3,
le composant multicouche (1) présentant une symétrie de rotation interrompue.

5. Composant multicouche (1) selon l'une quelconque des revendications précédentes,
le composant multicouche (1) étant réalisé sous forme d'actionneur piézo-électrique multicouche ou sous forme de capteur de pression multicouche.

6. Composant multicouche (1) selon l'une quelconque des revendications précédentes,
les électrodes extérieures (4a, 4b) présentant chacune une largeur (b1, b2) dans une direction perpendiculaire à une direction d'empilement des couches céramiques (2) et une hauteur (h1, h2) dans une direction parallèle à une direction d'empilement des couches céramiques (2), la largeur (b1) de la première électrode extérieure (4a) étant inférieure à la largeur (b2) de la deuxième électrode extérieure (4b) et/ou
la hauteur (h1) de la première électrode extérieure (4a) étant supérieure à la hauteur (h2) de la deuxième électrode extérieure (4b).

7. Composant multicouche (1) selon l'une quelconque des revendications précédentes,
les électrodes extérieures (4a, 4b) présentant une forme géométrique différente et/ou une taille différente.

8. Utilisation d'électrodes extérieures (4a, 4b) pour caractériser l'attribution de polarité différente des électrodes extérieures (4a, 4b) d'un composant multicouche (1) selon l'une quelconque des revendications 1 à 7.

9. Utilisation selon la revendication 8,
les électrodes extérieures (4a, 4b) présentant une forme géométrique différente et/ou une taille différente.
